(19) **Europäisches Patentamt / European Patent Office / Office européen des brevets**

(11) **EP 3 499 331 B1**

(12) **EUROPEAN PATENT SPECIFICATION**

(45) Date of publication and mention of the grant of the patent:
**26.01.2022 Bulletin 2022/04**

(21) Application number: **18195845.5**

(22) Date of filing: **21.09.2018**

(51) International Patent Classification (IPC):
**G05B 23/02** (2006.01)   **H01L 21/00** (2006.01)

(52) Cooperative Patent Classification (CPC):
**G05B 23/0243**

(54) **MONITORING SYSTEM, LEARNING APPARATUS, LEARNING METHOD, MONITORING APPARATUS, AND MONITORING METHOD**

ÜBERWACHUNGSSYSTEM, LERNVORRICHTUNG, LERNVERFAHREN, ÜBERWACHUNGSVORRICHTUNG UND ÜBERWACHUNGSVERFAHREN

SYSTÈME DE SURVEILLANCE, DISPOSITIF D'APPRENTISSAGE, PROCÉDÉ D'APPRENTISSAGE, APPAREIL DE SURVEILLANCE ET PROCÉDÉ DE SURVEILLANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.12.2017 JP 2017238786**

(43) Date of publication of application:
**19.06.2019 Bulletin 2019/25**

(73) Proprietor: **OMRON CORPORATION**
**Kyoto-shi, Kyoto 600-8530 (JP)**

(72) Inventors:
• **OTA, Yuya**
**Kyoto-shi, Kyoto 600-8530 (JP)**
• **FUJII, Toru**
**Kyoto-shi, Kyoto 600-8530 (JP)**
• **EGAMI, Shin**
**Kyoto-shi, Kyoto 600-8530 (JP)**
• **TSURUTA, Kosuke**
**Kyoto-shi, Kyoto 600-8530 (JP)**
• **KOYAMA, Hiroki**
**Kyoto-shi, Kyoto 600-8530 (JP)**

(74) Representative: **Horn Kleimann Waitzhofer**
**Patentanwälte PartG mbB**
**Ganghoferstrasse 29a**
**80339 München (DE)**

(56) References cited:
**JP-A- 2003 031 456    US-A1- 2016 126 148**

## Description

### FIELD

The present invention relates to a learning apparatus and a learning method in a monitoring system for monitoring the state of a chemical solution used in an etching process performed by a wet etching apparatus; and to a monitoring system comprising the learning apparatus as well as a monitoring method comprising the steps of the learning method..

### BACKGROUND

Conventionally, various methods for monitoring the state of a component used in an etching apparatus have been proposed. For example, JP 2003-031456A proposes a method for monitoring the state of a consumable component using a relation that predicts the etching rate uniformity from the amount of time the consumable component is used. Specifically, according to the method proposed in JP 2003-031456A, a predicted value of the etching rate uniformity is calculated by substituting the amounts of time respective consumable components are used into a predetermined relation, and a combination of consumable components to be replaced is calculated based on the calculated predicted value of the etching rate uniformity. With this method, the timing of replacement of a consumable component can be specified based on the amount of time the consumable component is used.

US 2016/0126148 A1 discloses a system and a method for etching semiconductor wafers for integrated circuits using a wet etching process that results in the etching of the waver to a precise and uniform thickness. Also disclosed is a mathematical model that is used as a basis for adding small amounts of fresh chemical etchant so as to sustain a constant etch rate. The model is based on a number of wafers processed or on a time elapsed from etchant preparation.

JP 2003-031456A and US 2016/0126148 A1 each are examples of background art.

In a wet etching apparatus, when a chemical solution, which is a consumable component, deteriorates, a phenomenon (hereinafter referred to as "removal unevenness") in which a portion of a target area of the etching process remains unremoved will occur. The inventors of the present invention found that, since the removal unevenness cannot be appropriately predicted with the above-described etching rate uniformity, there is a problem in that, if replacement of the chemical solution is performed when a predicted value of the etching rate uniformity exceeds a threshold value, even chemical solutions that are still well usable will be replaced. That is to say, the inventors of the present invention found that there is a problem with a conventional method in that it is difficult to appropriately predict the timing at which removal unevenness will occur, and replacement of the chemical solution is performed more frequently than necessary, resulting in an increased wet etching cost.

### SUMMARY

The present invention has been made in view of the foregoing situation in an aspect, and aims to provide a technique that enables the timing at which removal unevenness will occur in a wet etching apparatus to be appropriately predicted.

To achieve the above-stated object, the present invention employs the following configuration.

That is to say, a monitoring system according to an aspect of the present invention is a monitoring system for monitoring the state of a chemical solution used in an etching process performed by a wet etching apparatus, the monitoring system including: a learning data acquisition unit configured to acquire, as learning data, a set of normal values of:

an accumulated operating time indicating the accumulated time for which the wet etching apparatus has operated from when the chemical solution has been replaced to when the etching process has been applied to one wafer,
an accumulated number of processed wafers indicating the accumulated number of wafers that have been processed from when the chemical solution has been replaced to when the etching process has been applied to the one wafer, and
a removal amount indicating the amount that has been removed by etching from the one wafer to which the etching process has been applied; a model construction unit configured to construct a predictive model that predicts a value of the removal amount depending on values of the accumulated operating time and the accumulated number of processed wafers, based on the normal values of the accumulated operating time, the accumulated number of processed wafers, and the removal amount contained in the learning data; an actual value acquisition unit configured to acquire actual values of the accumulated operating time, the accumulated number of processed wafers, and the removal amount with respect to the wet etching apparatus when it is in operation; an indicator value calculation unit configured to calculate a predicted value of the removal amount by inputting the acquired actual values of the accumulated operating time and the accumulated number of processed wafers to the predictive model, and calculate the difference between the calculated predicted value and the acquired actual value of the removal amount, as an indicator value serving as a measure of how necessary it is to replace the chemical solution; and an output unit configured to output information regarding replacement of the chemical solution based on the calculated indicator value.

A predictive model that predicts a value of the removal amount removed by etching depending on values of the accumulated operating time and the accumulated number of processed wafers can be constructed by analyzing data that is obtained while the wet etching apparatus is operating normally. The inventors of the present invention found that the greater the discrepancy between a predicted value of the removal amount derived from the predictive model and a corresponding actual value of the removal amount, the more likely that removal unevenness will occur in a target wet etching apparatus. That is to say, the inventors of the present invention found that the occurrence of removal unevenness can be predicted based on whether or not the difference between a predicted value of the removal amount obtained by inputting actual values of the accumulated operating time and the accumulated number of processed wafers to the predictive model and a corresponding actual value of the removal amount exceeds a certain value.

Note that the term "accumulated operating time" refers to the accumulated time for which the wet etching apparatus has operated from when the chemical solution has been replaced to immediately before the etching process has been applied to the wafer. The term "accumulated number of processed wafers" refers to the accumulated number of wafers that have been processed from when the chemical solution has been replaced to immediately before the etching process has been applied to the wafer. The term "removal amount" refers to the amount that has been removed by etching from the wafer to which the etching process has been applied by the wet etching apparatus.

Thus, the monitoring system according to the above-described configuration acquires a combination of normal values of the accumulated operating time, the accumulated number of processed wafers, and the removal amount as learning data, and constructs a predictive model that predicts a value of the removal amount depending on values of the accumulated operating time and the accumulated number of processed wafers, based on the acquired learning data. That is to say, the predictive model is constructed such that, upon input of values of the accumulated operating time and the accumulated number of processed wafers, the predictive model outputs a value of the removal amount removed by etching predicted from the input values of the accumulated operating time and the accumulated number of processed wafers.

Also, the monitoring system according to the above-described configuration acquires actual values of the accumulated operating time, the accumulated number of processed wafers, and the removal amount with respect to a wet etching apparatus when it is in operation, and calculates a predicted value of the removal amount removed by etching, by inputting the acquired actual values of the accumulated operating time and the accumulated number of processed wafers to the predictive model. Then, the monitoring system according to the above-described configuration calculates the difference between the predicted value and the actual value of the removal amount, as an indicator value serving as a measure of how necessary it is to replace the chemical solution, and outputs information regarding replacement of the chemical solution based on the calculated indicator value.

Therefore, the monitoring system according to the above-described configuration can appropriately construct a predictive model that predicts a value of the removal amount from values of the accumulated operating time and the accumulated number of processed wafers. Moreover, the monitoring system according to the above-described configuration can derive a predicted value of the removal amount with respect to a wet etching apparatus when it is in operation, using the constructed predictive model, calculate the difference between the predicted value and an actual value of the removal amount, and outputs information regarding replacement of the chemical solution based on the calculated difference. Thus, with the monitoring system according to the above-described configuration, the timing at which removal unevenness will occur in a wet etching apparatus can be appropriately predicted based on the above-described findings of the inventors of the present invention. Moreover, use of the monitoring system according to the above-described configuration can suppress excessive replacement of the chemical solution in the target wet etching apparatus, and can reduce the wet etching cost.

Note that the difference (i.e., indicator value) between the predicted value and the actual value of the removal amount may be expressed as the result of subtraction of the predicted value and the actual measured value, or may be expressed as the ratio between the predicted value and the actual value. Also, the predictive model is configured to indicate the relationship of the accumulated operating time and the accumulated number of processed wafers with the removal amount, by statistically analyzing the learning data. The type of the predictive model needs not be limited and may be selected as appropriate, depending on the embodiment, as long as the predictive model is obtained through such statistical analysis. Examples of the predictive model may include a regression model, a neural network, a decision tree model, and the like.

In the monitoring system according to the above-described aspect, the output unit may be configured to compare the calculated indicator value and a threshold value and to output a message for prompting replacement of the chemical solution as the information regarding replacement of the chemical solution, if it is judged that the indicator value exceeds the threshold value as a result of the comparison. With this configuration, a monitoring system that prompts replacement of the chemical solution at appropriate timing can be provided.

In the monitoring system according to the above-described aspect, the threshold value may be set based on the difference between an output value obtained by inputting values of the accumulated operating time and the accumulated number of processed wafers when an abnormality has occurred during the etching process in the wet etching apparatus to the predictive model and a value of the removal amount when the abnormality has occurred. With this configuration, a threshold value constituting an indicator used to determine the timing of replacement of the chemical solution can be set appropriately.

In the monitoring system according to the above-described aspect, the model construction unit may be configured to construct the predictive model by performing regression analysis of normal values of the accumulated operating time, the accumulated number of processed wafers, and the removal amount contained in the learning data. With this configuration, a predictive model that predicts the removal amount from the accumulated operating time and the accumulated number of processed wafers can be constructed appropriately.

In the monitoring system according to the above-described aspect, the wet etching apparatus may include a chemical solution replacement unit configured to perform replacement of the chemical solution. Moreover, in the monitoring system according to the above-described aspect, the output unit may be configured to output an instruction to replace the chemical solution to the chemical solution replacement unit of the wet etching apparatus, as the information regarding replacement of the chemical solution. With this configuration, replacement of the chemical solution can be automated.

Note that other embodiments of the monitoring system according to the above respective embodiments may also include an information processing method and a program that realize the above respective configurations, and a storage medium that stores such a program and can be read by a computer or another kind of apparatus, machine, or the like. Here, a storage medium that can be read by a computer or the like is a medium that accumulates information such as a program by means of an electric, magnetic, optical, mechanical, or chemical effect. Moreover, the monitoring system according to the above respective embodiments may be constituted by one or more information processing apparatuses.

A learning apparatus according to an aspect of the present invention includes a learning data acquisition unit configured to acquire, as learning data, a set of normal values of:

an accumulated operating time indicating the accumulated time for which a wet etching apparatus has operated from when a chemical solution has been replaced to when an etching process has been applied to one wafer,
an accumulated number of processed wafers indicating the accumulated number of wafers that have been processed from when the chemical solution has been replaced to when the etching process has been applied to the one wafer, and

a removal amount indicating the amount that has been removed by etching from the one wafer to which the etching process has been applied; and a model construction unit configured to construct a predictive model that predicts a value of the removal amount depending on values of the accumulated operating time and the accumulated number of processed wafers, based on the normal values of the accumulated operating time, the accumulated number of processed wafers, and the removal amount contained in the learning data.

In the learning apparatus according to the above-described aspect, the model construction unit may be configured to construct the predictive model by performing regression analysis of normal values of the accumulated operating time, the accumulated number of processed wafers, and the removal amount contained in the learning data.

Also, a learning method according to an aspect of the present invention is a learning method including: a step of acquiring, as learning data, a set of normal values of:

an accumulated operating time indicating the accumulated time for which a wet etching apparatus has operated from when a chemical solution has been replaced to when an etching process has been applied to one wafer,
an accumulated number of processed wafers indicating the accumulated number of wafers that have been processed from when the chemical solution has been replaced to when the etching process has been applied to the one wafer, and
a removal amount indicating the amount that has been removed by etching from the one wafer to which the etching process has been applied; and a step of constructing a predictive model that predicts a value of the removal amount depending on values of the accumulated operating time and the accumulated number of processed wafers, based on the normal values of the accumulated operating time, the accumulated number of processed wafers, and the removal amount contained in the learning data. The steps may, for example, be executed by a computer.

Also, a monitoring method according to an aspect of the present invention is a monitoring method including: a step of acquiring, with respect to a wet etching apparatus when it is in operation, actual values of:

an accumulated operating time indicating the accumulated time for which the wet etching apparatus has operated from when a chemical solution has been replaced to when an etching process has been applied to one wafer,
an accumulated number of processed wafers indicating the accumulated number of wafers that have been processed from when the chemical solution has been replaced to when the etching process has been applied to the one wafer, and

a removal amount indicating the amount that has been removed by etching from the one wafer to which the etching process has been applied; a step of calculating a predicted value of the removal amount by inputting the acquired actual values of the accumulated operating time and the accumulated number of processed wafers to a predictive model that is constructed so as to predict a value of the removal amount depending on values of the accumulated operating time and the accumulated number of processed wafers; a step of calculating the difference between the calculated predicted value and the acquired actual value of the removal amount, as an indicator value serving as a measure of how necessary it is to replace the chemical solution; and a step of outputting information regarding replacement of the chemical solution based on the calculated indicator value. The steps may be, for example, executed by a computer.

Further aspects of the invention relate to: a computer program comprising instructions to cause the learning apparatus according to aspects of the invention to execute the steps of the learning method according to aspects of invention; a computer program comprising instructions to cause the monitoring system according to aspects of the invention to execute the steps of the monitoring method according to aspects of the invention; and to a computer-readable medium having stored thereon one of the computer programs according to aspects of the invention.

The present invention can provide a technique that enables the timing at which removal unevenness will occur in a wet etching apparatus to be appropriately predicted.

BRIEF DESCRIPTION OF THE DRAWINGS

FIG. 1 schematically shows an example of an instance where the present invention is applied.
FIG. 2A shows the results of measurement of an accumulated operating time, an accumulated number of processed wafers, and a removal amount.
FIG. 2B shows the results of calculation of differences between predicted values and actual values of the removal amount.
FIG. 3 schematically shows an example of a hardware configuration of a monitoring system according to an embodiment.
FIG. 4 schematically shows an example of a software configuration of the monitoring system according to this embodiment.
FIG. 5 shows an example of a processing procedure performed by the monitoring system according to this embodiment when constructing a predictive model.
FIG. 6 schematically shows an example of operation data indicating the operation state of a wet etching apparatus according to this embodiment.
FIG. 7 schematically shows an example of a data table for managing learning data according to this embodiment.
FIG. 8 schematically shows an example of a data table for managing the predictive model according to this embodiment.
FIG. 9 shows an example of a processing procedure performed by the monitoring system according to this embodiment when monitoring the state of a chemical solution in the wet etching apparatus.
FIG. 10 schematically shows an example of the results of calculation of an indicator value according to this embodiment.
FIG. 11 schematically shows an example of a software configuration of a monitoring system according to a modification.
FIG. 12 schematically shows an example of a configuration of a monitoring system according to a modification.
FIG. 13 schematically shows an example of a configuration of a wet etching apparatus according to the modification.

DETAILED DESCRIPTION

Hereinafter, an embodiment according to an aspect of the present invention (also referred to as "the embodiment" below) will be described based on the drawings. However, the embodiment described below is merely an example of the present invention in every respect. Needless to say, various improvements and modifications may be made without departing from the scope of the present invention. That is to say, to implement the present invention, a specific configuration corresponding to an embodiment may also be employed as appropriate. Note that, although data that is used in the embodiment is described using natural language, more specifically, the data is defined by pseudo-language, commands, parameters, machine language, or the like that can be recognized by a computer.

§1 Application example

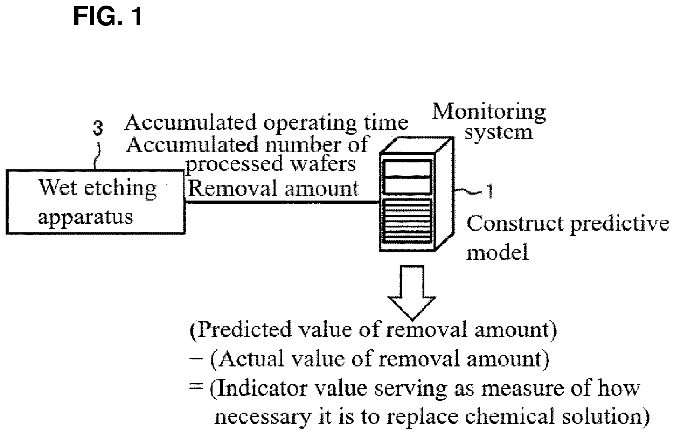

First, an example of an instance where the present invention is applied will be described using FIG. 1. FIG. 1 schematically shows an example of an instance of using a monitoring system 1 according to this embodiment.

The monitoring system 1 according to this embodiment is an information processing apparatus for monitoring the state of a chemical solution for use in an etching process performed by a wet etching apparatus 3. The type of the wet etching apparatus 3 needs not be limited, and may be selected as appropriate, depending on the embodiment. A known wet etching apparatus may be used as the wet etching apparatus 3.

In order to specify the situations in which removal unevenness is likely to occur, data on an accumulated operating time, an accumulated number of processed wafers, and a removal amount was collected under the following conditions using a known wet etching apparatus.

<Data collecting conditions>

- Wet etching apparatus: DIP type (batch processing) wet bench
- Type of chemical solution: iodine/potassium iodide etchant for Au
- Type of wafer: silicon wafer
- Processing of wafer: Au is deposited on a silicon wafer through sputtering, and an interconnect pattern is formed using a photoresist.
- Replacement frequency of chemical solution: at least once a month (this changed for a while in the sixth month and thereafter)

The term "accumulated operating time" as used herein refers to the accumulated time for which the wet etching apparatus was operated from when the chemical solution was replaced to immediately before the etching process was applied to a wafer. The term "accumulated number of processed wafers" refers to the accumulated number of wafers that have been processed from when the chemical solution was replaced to immediately before the etching process was applied to the wafer. The term "removal amount" refers to the amount that has been removed by etching from the wafer to which the etching process was applied by the wet etching apparatus.

While data was collected, each time the chemical solution was replaced, the values of the accumulated operating time and the accumulated number of processed wafers were reset to 0. Dimensions between electrodes of a wafer change as a result of performing the etching process. The resistance value between the electrodes varies in accordance with the change in the dimensions between the electrodes. Thus, the resistance value of a wafer was measured before and after the etching process was performed, the amount of change in the resistance value of the wafer was calculated from the difference between the obtained measured values, and, based on the calculated amount of change in the resistance value of the wafer, the removal amount removed by etching from the wafer was obtained. Note that the wet etching apparatus used to collect the data houses a single lot of wafers (three wafers) in its magazine and etches the wafers in a single lot together, and therefore, the removal amount was measured through sampling from each lot.

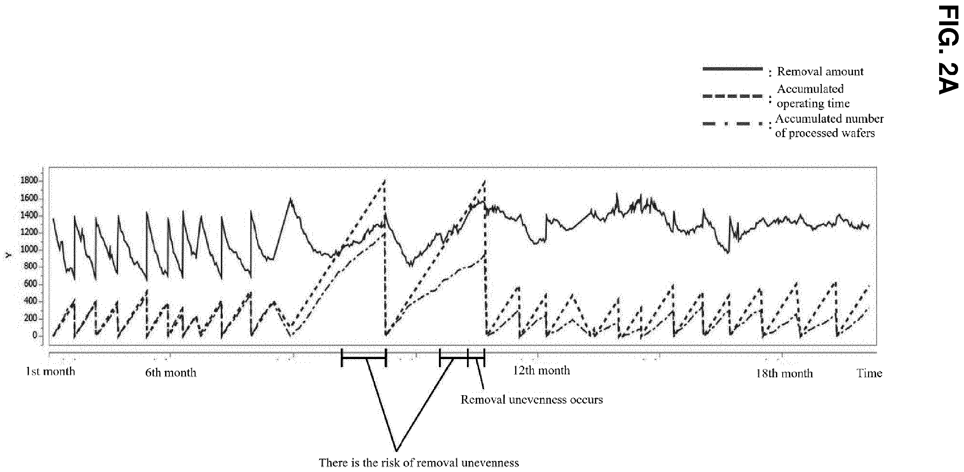

FIG. 2A shows the collected data. During a period in which the wet etching apparatus operated normally, that is, during a period in which removal unevenness did not occur on wafers, the removal amount removed from a wafer basically decreased in accordance with the accumulated operating time and the accumulated number of processed wafers. On the other hand, in the sixth month and thereafter when the frequency of replacement of the chemical solution was reduced, at the time when the accumulated operating time and the accumulated number of processed wafers had increased to a certain extent, the removal amount removed from a wafer that had been decreasing started to increase. Then, removal unevenness occurred during a period indicated in FIG. 2A.

These trends showed that a situation in which, although the accumulated operating time and the accumulated number of processed wafers are increasing, the removal amount removed from a wafer is increasing may increase the risk of removal unevenness. Thus, a predictive model that predicts a value of the removal amount depending on values of the accumulated operating time and the accumulated number of processed wafers was constructed, using data collected during a period in which the removal amount removed from a wafer tended to decrease. The data was analyzed using regression analysis to construct the predictive model (regression model). Then, the differences between predicted values of the removal amount derived from the constructed predictive model and actual measured values (data in FIG. 2A) of the removal amount were calculated.

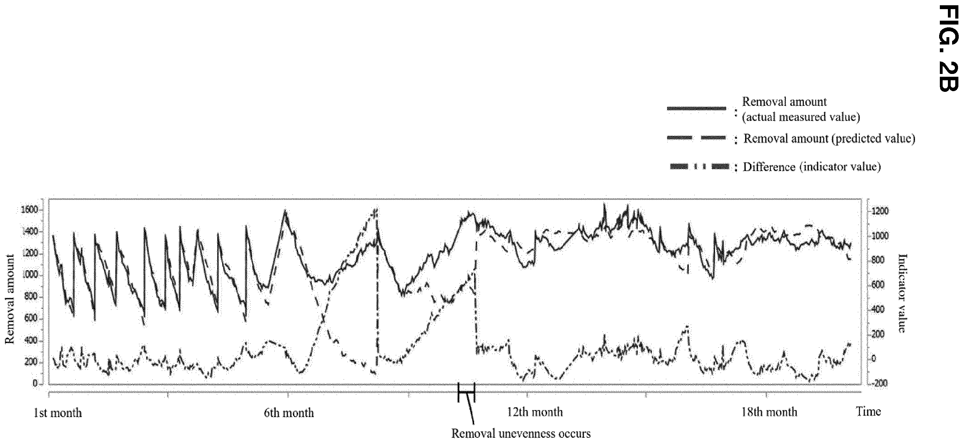

FIG. 2B shows the results of the calculation of the differences between the predicted values and the actual values of the removal amount. As shown in FIG. 2B, it was found that the higher the risk of removal unevenness, the greater the difference between a predicted value of the removal amount derived from the predictive model and a corresponding actual measured value of the removal amount. Therefore, the inventors of the present invention found that the risk of removal unevenness can be predicted by using the difference between a predicted value of the removal amount derived from a predictive model and a corresponding actual measured value of the removal amount, as an indicator value.

Thus, as shown in FIG. 1, in a learning phase, the monitoring system 1 acquires a set of normal values of the accumulated operating time, the accumulated number of processed wafers, and the removal amount with respect to the wet etching apparatus 3, as learning data. Then, based on the acquired learning data, the monitoring system 1 constructs a predictive model that predicts a value of the removal amount depending on values of the accumulated operating time and the accumulated number of processed wafers. The predictive model is constructed such that, upon input of values (actual values) of the accumulated operating time and the accumulated number of processed wafers, the predictive model outputs a value (predicted value) of the removal amount removed by etching predicted from the input values of the accumulated operating time and the accumulated number of processed wafers.

On the other hand, in a monitoring phase, the monitoring system 1 acquires actual values of the accumulated operating time, the accumulated number of processed wafers, and the removal amount with respect to the wet etching apparatus 3 when it is in operation. Subsequently, the monitoring system 1 inputs the acquired actual values of the accumulated operating time and the accumulated number of processed wafers to the predictive model, thereby calculating a predicted value of the removal amount removed by etching with respect to the wet etching apparatus 3. Then, the monitoring system 1 calculates the difference between the calculated predicted value and the acquired actual value of the removal amount as an indicator value serving as a measure of how necessary it is to replace the chemical solution, and outputs information regarding replacement of the chemical solution, based on the calculated indicator value.

In this manner, the monitoring system 1 according to this embodiment can appropriately construct a predictive model that predicts the value of the removal amount from the values of the accumulated operating time and the accumulated number of processed wafers with respect to the wet etching apparatus 3. Also, the monitoring system 1 according to this embodiment can derive a predicted value of the removal amount with respect to the wet etching apparatus 3 when it is in operation, by using the constructed predictive model, calculate the difference between the predicted value and a corresponding actual value of the removal amount, and output information regarding replacement of the chemical solution based on the calculated difference.

Therefore, according to this embodiment, the timing at which removal unevenness will occur in the wet etching apparatus 3 can be appropriately predicted based on the above-described findings of the inventors of the present invention. Accordingly, use of the monitoring system 1 according to this embodiment can suppress excessive replacement of the chemical solution in the wet etching apparatus 3, and can reduce the wet etching cost.

Note that the wet etching apparatus 3 of the learning phase may be different from the wet etching apparatus 3 of the monitoring phase. That is to say, the wet etching apparatus from which learning data is acquired to construct a predictive model and the wet etching apparatus to be monitored for the occurrence of removal unevenness may be different.

§2 Configuration example

[Hardware configuration]

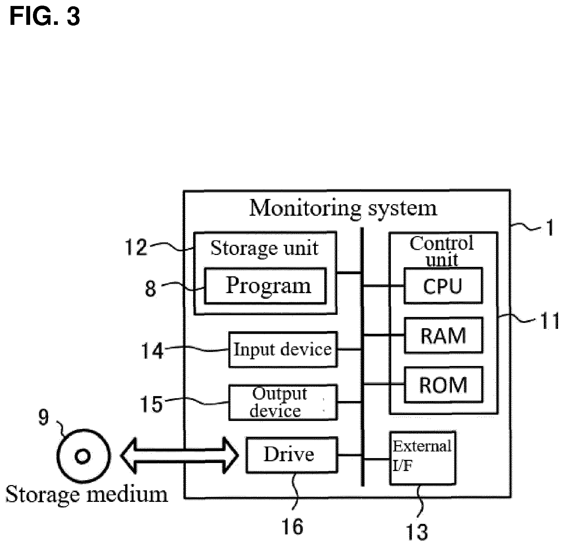

Next, an example of a hardware configuration of the monitoring system 1 according to this embodiment will be described using FIG. 3. FIG. 3 schematically shows an example of the hardware configuration of the monitoring system 1 according to this embodiment.

As shown in FIG. 3, the monitoring system 1 according to this embodiment is a computer in which a control unit 11, a storage unit 12, an external interface 13, an input device 14, an output device 15, and a drive 16 are electrically connected to one another. Note that, in FIG. 3, the external interface is denoted as "external I/F".

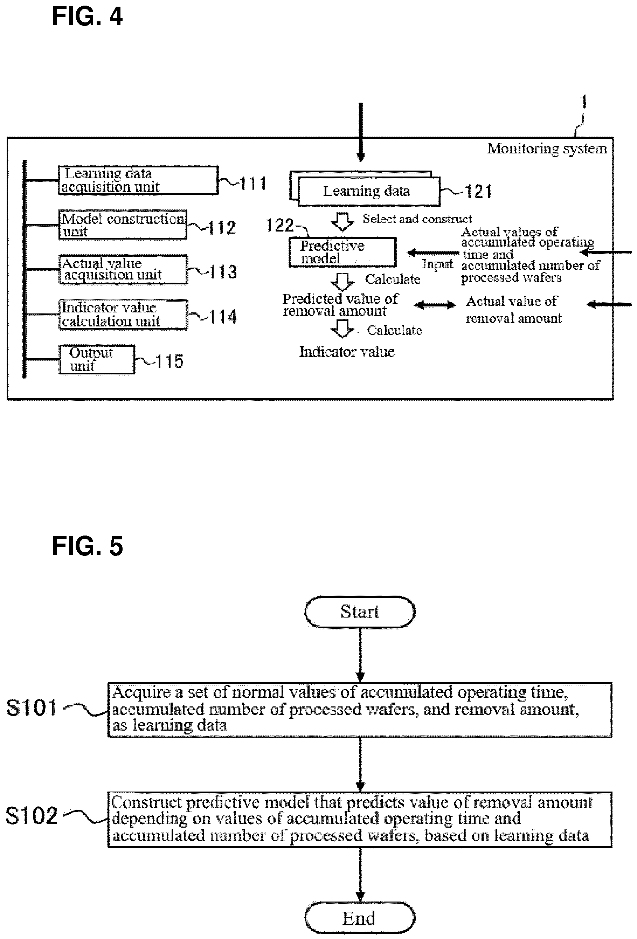

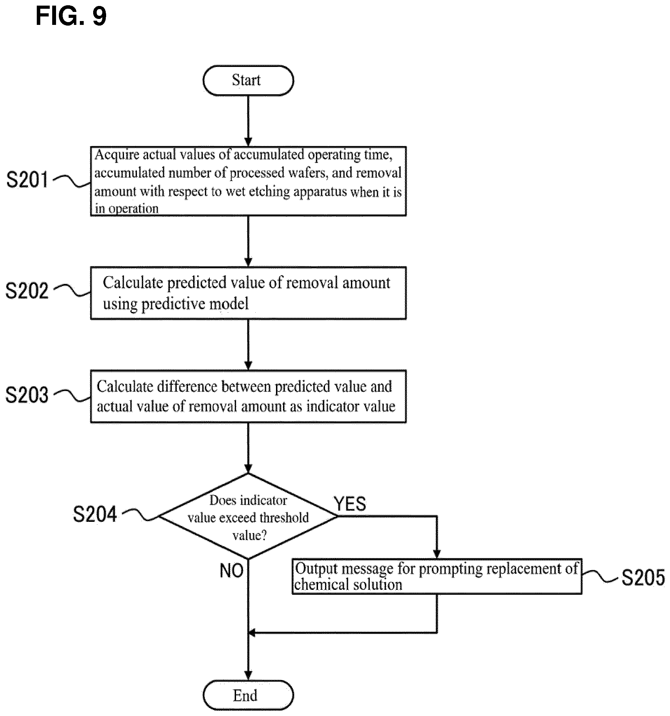

The control unit 11 includes a CPU (Central Processing Unit), which is a hardware processor, a RAM (Random Access Memory), a ROM (Read Only Memory), and the like, and controls the constituent elements as appropriate for information processing. The storage unit 12 is an auxiliary storage such as a hard disk drive or a solid-state drive, for example, and stores various kinds of information such as a program 8 to be executed by the control unit 11. The program 8 is a program for causing the monitoring system 1 to execute learning processing (FIG. 5) and monitoring processing (FIG. 9), which will be described later. The details will be described later.

The external interface 13 is a dedicated port, a USB (Universal Serial Bus) port, or the like, for example, and is an interface for connection to an external device. The type and number of external interfaces 13 may be determined as appropriate, depending on the embodiment. The monitoring system 1 is connected to the wet etching apparatus 3 via the external interface 13.

The input device 14 is a device for performing input, such as a mouse or a keyboard, for example. The output device 15 is a device for performing output, such as a display or a speaker, for example. An operator can operate the monitoring system 1 via the input device 14 and the output device 15.

The drive 16 is a CD drive, a DVD drive, or the like, for example, and is a drive device for loading a program stored in a storage medium 9. The type of the drive 16 may be selected as appropriate in accordance with the type of storage medium 9. The program 8 may also be stored in this storage medium 9.

The storage medium 9 is a medium that accumulates information such as that of a program by means of an electric, magnetic, optical, mechanical, or chemical effect, so that a computer or other kinds of apparatuses, machines, or the like can read the recorded information such as that of a program. The monitoring system 1 may also acquire the program 8 from this storage medium 9.

Here, FIG. 3 shows a disk-type storage medium such as a CD or DVD as an example of the storage medium 9. However, the type of the storage medium 9 is not limited to a disk type, and may also be a type other than a disk type. Examples of a storage medium of a type other than a disk type may include a semiconductor memory such as a flash memory.

Note that, regarding the specific hardware configuration of the monitoring system 1, constituent elements may be omitted, replaced, and added as appropriate, depending on the embodiment. For example, the control unit 11 may also include a plurality of processors. The monitoring system 1 may also be constituted by a plurality of information processing apparatuses. The monitoring system 1 may also be an information processing apparatus designed exclusively for a service to be provided, as well as a general-purpose server device, a PC (Personal Computer), or the like.

[Software configuration]

Next, an example of a software configuration of the monitoring system 1 according to this embodiment will be described using FIG. 4. FIG. 4 schematically shows an example of the software configuration of the monitoring system 1 according to this embodiment.

The control unit 11 in the monitoring system 1 loads the program 8 stored in the storage unit 12 to the RAM. The control unit 11 then interprets and executes the program 8 loaded to the RAM, using the CPU, and controls the constituent elements. Thus, as shown in FIG. 4, the monitoring system 1 according to this embodiment is configured as a computer including a learning data acquisition unit 111, a model construction unit 112, an actual value acquisition unit 113, an indicator value calculation unit 114, and an output unit 115, as software modules.

In the learning phase, the learning data acquisition unit 111 acquires a set of normal values of the accumulated operating time, the accumulated number of processed wafers, and the removal amount as learning data 121. The model construction unit 112 constructs a predictive model 122 that predicts the value of the removal amount depending on the values of the accumulated operating time and the accumulated number of processed wafers, based on the normal values of the accumulated operating time, the accumulated number of processed wafers, and the removal amount contained in the learning data 121.

Next, in the monitoring phase, the actual value acquisition unit 113 acquires actual values of the accumulated operating time, the accumulated number of processed wafers, and the removal amount with respect to the wet etching apparatus 3 when it is in operation. The indicator value calculation unit 114 calculates a predicted value of the removal amount by inputting the acquired actual values of the accumulated operating time and the accumulated number of processed wafers to the predictive model 122, and calculates the difference between the calculated predicted value and the acquired actual value of the removal amount, as an indicator value serving as a measure of how necessary it is to replace the chemical solution. The output unit 115 outputs information regarding replacement of the chemical solution based on the calculated indicator value.

The software modules of the monitoring system 1 will be described in detail in an operation example, which will be described later. Note that this embodiment describes an example in which all of the software modules of the monitoring system 1 are realized by a general-purpose CPU. However, some or all of those software modules may also be realized by one or more dedicated processors. Regarding the software configuration of the monitoring system 1, software modules may be omitted, replaced, and added as appropriate, depending on the embodiment.

§3 Operation example

Next, an operation example of the monitoring system 1 will be described. The monitoring system 1 according to this embodiment performs two types of operations: the operation of the learning phase in which the predictive model 122 is constructed and the operation of the monitoring phase in which the state of the chemical solution in the wet etching apparatus 3 is monitored using the predictive model 122 constructed in the learning phase. Hereinafter, processing procedures of the respective phases will be described.

[Learning phase]

First, a processing procedure of the learning phase, in which the predictive model 122 is constructed, will be described using FIG. 5. FIG. 5 shows an example of the processing procedure of the learning phase of the monitoring system 1 according to this embodiment. The processing procedure of the learning phase described below is an example of a "learning method" of the present invention. However, the processing procedure described below is merely an example, and processing may be modified to the extent possible. Regarding the processing procedure described below, steps may be omitted, replaced, and added as appropriate, depending on the embodiment.

Step S101

First, in step S101, the control unit 11 functions as the learning data acquisition unit 111, and acquires a set of normal values of the accumulated operating time, the accumulated number of processed wafers, and the removal amount as the learning data 121.

The method for acquiring the learning data 121 may be selected as appropriate, depending on the embodiment. For example, the control unit 11 may acquire operation data that indicates the operation state of the wet etching apparatus 3 during a period in which an abnormality such as removal unevenness does not occur. The control unit 11 may then extract the values of the accumulated operating time, the accumulated number of processed wafers, and the removal amount from the acquired operation data and thereby acquire the learning data 121. Note that the operation data needs not be acquired in real time, and the control unit 11 may also acquire the operation data after the wet etching apparatus 3 stops operating.

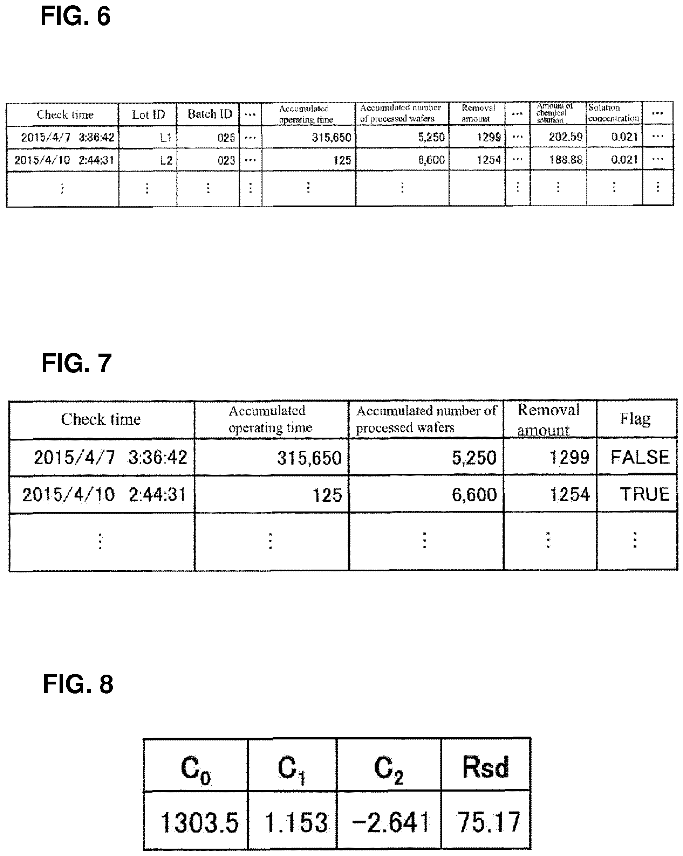

FIG. 6 schematically shows an example of the operation data of the wet etching apparatus 3. The control unit 11 can acquire the operation data from, for example, the wet etching apparatus 3 itself, a known checking apparatus (not shown) that checks the operation of the wet etching apparatus 3, or the like. The operation data shown as an example in FIG. 6 has fields storing the values of "check time", "lot ID", "batch ID", "accumulated operating time", "accumulated number of processed wafers", "removal amount", "amount of chemical solution", and "solution concentration", respectively.

"Check time" indicates the time at which the operation state of the wet etching apparatus 3 is checked. "Lot ID" and "batch ID" are identifiers for identifying wafers that have been etched in the wet etching apparatus 3. "Amount of chemical solution" indicates the amount of the chemical solution used in the etching process. "Solution concentration" indicates the concentration of the chemical solution used in the etching process.

The control unit 11 can extract the fields storing the check time, the accumulated operating time, the accumulated number of processed wafers, and the removal amount from the above-described operation data and thereby acquire the learning data 121. The control unit 11 may then store the acquired learning data 121 in the storage unit 12 in a predetermined format.

FIG. 7 schematically shows an example of a data table for managing the learning data 121. The data table shown as an example in FIG. 7 has fields storing the values of "check time", "accumulated operating time", "accumulated number of processed wafers", "removal amount", and "flag", respectively. The control unit 11 may store the learning data 121 in such a data table format. However, the data format used to manage the learning data 121 needs not be limited to a table format such as that described above, and may be selected as appropriate, depending on the embodiment. After acquiring the learning data 121, the control unit 11 advances the processing to the next step S102.

Note that the flag indicates whether or not that record (line data) is to be used as the learning data 121. In FIG. 7, "FALSE" indicates that the record is not to be used as the learning data 121, and "TRUE" indicates that the record is to be used as the learning data 121. In this step S101, when extracting values of the above-described fields from the operation data, the control unit 11 may select whether or not to use respective records extracted from the operation data as the learning data 121.

This selection may also be performed by the operator, for example. In this case, the control unit 11 outputs the records extracted from the operation data to the output device 15 and receives selections with regard to whether or not the respective records are to be used as the learning data 121. The operator operates the input device 14 to select whether or not to use the respective records as the learning data 121. The control unit 11 judges whether or not to use the respective records extracted from the operation data as the learning data 121, based on the operation of the input device 14 that is performed by the operator.

Moreover, from FIGS. 2A and 2B above, when the removal amount removed by etching tends to decrease as the accumulated operating time and the accumulated number of processed wafers increase, there is substantially no risk of removal unevenness, whereas when the removal amount tends to increase as the accumulated operating time and the accumulated number of processed wafers increase, it is predicted that the risk of removal unevenness increases. Thus, the control unit 11 may judge whether or not to use the respective records extracted from the operation data as the learning data 121, based on the value of the removal amount and without resorting to the selection performed by the operator. For example, the control unit 11 may refer to the value of the removal amount of certain records, and judge that those records are to be used as the learning data 121, if the value of the removal amount tends to decrease. On the other hand, the control unit 11 may judge that those records are not to be used as the learning data 121, if the value of the removal amount tends to increase. However, the method for selecting the learning data 121 is not limited to this example, and a portion of the data during a period in which the value of the removal amount tends to increase may also be used as the learning data 121.

Step S102

In the next step S102, the control unit 11 functions as the model construction unit 112, and constructs the predictive model 122 that predicts a value of the removal amount depending on values of the accumulated operating time and the accumulated number of processed wafers, based on the normal values of the accumulated operating time, the accumulated number of processed wafers, and the removal amount contained in the learning data 121 acquired in step S101. The type of the predictive model 122 may be selected as appropriate, depending on the embodiment. For example, a regression model may be employed as the predictive model 122. The regression model can be expressed by the following mathematical equation (1):

$$y = c_0 + c_1 x_1 + c_2 x_2 \qquad (1)$$

Note that y corresponds to the removal amount, $x_1$ corresponds to the accumulated operating time, and $x_2$ corresponds to the accumulated number of processed wafers. The items to which $x_1$ and $x_2$ correspond may also be exchanged. Also, $C_0$ is an intercept, and $C_1$ and $C_2$ are regression coefficients. The control unit 11 calculates the values of $C_0$ to $C_2$ by performing regression analysis of normal values of the accumulated operating time, the accumulated number of processed wafers, and the removal amount contained in the learning data 121, and thereby constructs the predictive model 122 (regression model). The control unit 11 may store the calculated values of $C_0$ to $C_2$ in a predetermined format in the storage unit 12 in order to save the constructed predictive model 122.

FIG. 8 schematically shows an example of a data table for managing the predictive model 122. The data table shown as an example in FIG. 8 has fields storing the values of $C_0$ to $C_2$ and a standard deviation (Rsd), respectively. The control unit 11 may save the predictive model 122 in such a data table format. However, the data format used to manage the predictive model 122 needs not be limited to a table format such as that described above, and may be selected as appropriate, depending on the embodiment. After constructing the predictive model 122, the control unit 11 ends the processing of the learning phase according to this operation example.

Note that the standard deviation (Rsd) field stores a standard deviation of errors of the predictive model 122 (regression model) relative to the learning data 121. The control unit 11 can calculate the value of the standard deviation based on the predictive model 122 constructed through the regression analysis and the learning data 121. However, the value of the standard deviation is not a constituent element of the predictive model 122. Therefore, calculation of the standard deviation may also be omitted. That is to say, the standard deviation (Rsd) field may also be omitted from the above-described data table.

Moreover, the type of the predictive model 122 needs not be limited to a specific type, as long as the predictive model 122 is obtained through statistical analysis that can derive the relationship of the accumulated operating time and the accumulated number of processed wafers with the removal amount. That is to say, the type of the predictive model 122 needs not be limited to the above-described regression model, and may be selected as appropriate, depending on the embodiment, as long as the predictive model 122 can output, in response to input of values of the accumulated operating time and the accumulated number of processed wafers, a value of the removal amount predicted from the input values of the accumulated operating time and the accumulated number of processed wafers. The above-described regression model, as well as a neural network, a decision tree model (a regression tree, a random forest, etc.), or the like, for example, can be used as the predictive model 122.

[Monitoring phase]

Next, a processing procedure of the monitoring phase, in which the state of the chemical solution in the wet etching apparatus 3 is monitored using the constructed predictive model 122, will be described using FIG. 9. FIG. 9 shows an example of a processing procedure of the monitoring phase of the monitoring system 1 according to this embodiment. The processing procedure of the monitoring phase described below is an example of a "monitoring method" of the present invention. However, the processing procedure described below is merely an example, and processing may be modified to the extent possible. Regarding the processing procedure described below, steps may be omitted, replaced, and added as appropriate, depending on the embodiment.

Step S201

First, in step S201, the control unit 11 functions as the actual value acquisition unit 113, and acquires actual values of the accumulated operating time, the accumulated number of processed wafers, and the removal amount with respect to the wet etching apparatus 3 when it is in operation.

The method for acquiring the actual values may be selected as appropriate, depending on the embodiment. For example, the control unit 11 may acquire the same operation data as in the above-described step S101 in real time from the wet etching apparatus 3 when it is in operation, a checking apparatus (not shown), or the like. The control unit 11 then extracts values of the respective fields of the accumulated operating time, the accumulated number of processed wafers, and the removal amount contained in the acquired operation data, and can thereby acquire actual values of the accumulated operating time, the accumulated number of processed wafers, and the removal amount. After acquiring the actual values, the control unit 11 advances the processing to the next step S202.

Step S202

In the next step S202, the control unit 11 functions as the indicator value calculation unit 114, and calculates a predicted value of the removal amount by inputting the actual values of the accumulated operating time and the accumulated number of processed wafers that have been acquired in step S201 to the predictive model 122.

This step S202 is performed as appropriate in accordance with the type of the predictive model 122 that has been constructed in the above-described step S102. According to this embodiment, the predictive model 122 is constructed using the above-described regression model. Therefore, the control unit 11 performs calculation processing of the predictive model 122 (regression model) expressed by the mathematical equation (1) above, by substituting the actual values of the accumulated operating time and the accumulated number of processed wafers that have been obtained in step S201 for $x_1$ and $x_2$, respectively, and using the values of $C_0$ to $C_2$ that have been calculated in step S102. In this manner, the control unit 11 can calculate the predicted value of the removal amount. After calculating the predicted value of the removal amount, the control unit 11 advances the processing to the next step S203.

Step S203

In the next step S203, the control unit 11 calculates the difference between the predicted value of the removal amount calculated in step S202 and the actual value of the removal amount acquired in step S201, thereby acquiring an indicator value serving as a measure of how necessary it is to replace the chemical solution in the wet etching apparatus 3. Note that the difference between the predicted value and the actual value of the removal amount may be expressed as the result of subtraction of the predicted value and the actual value, or may be expressed as the ratio between the predicted value and the actual value.

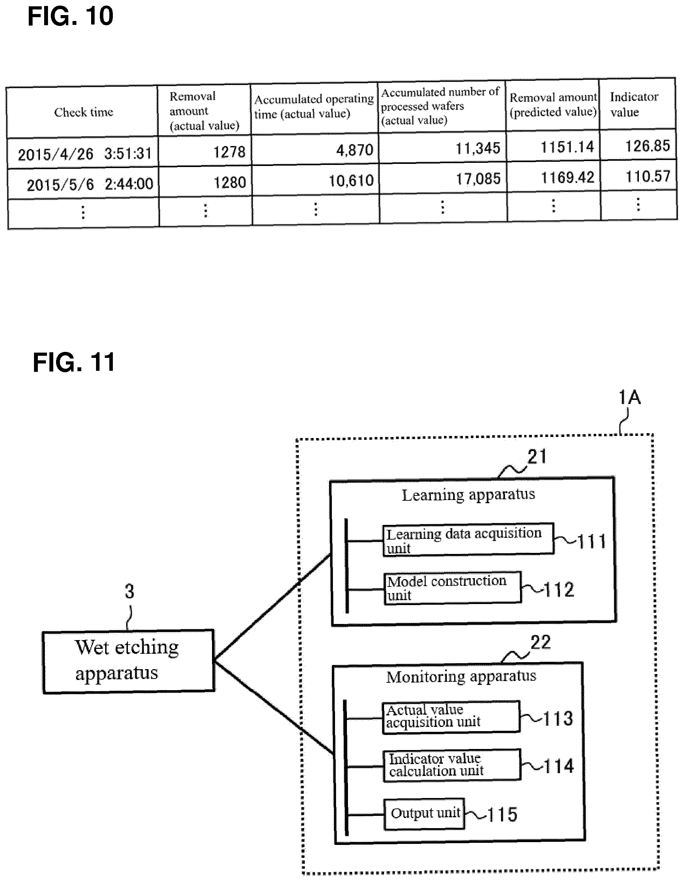

FIG. 10 schematically shows an example of the results of calculation of an indicator value. A data table shown as an example in FIG. 10 has fields storing the actual values acquired in step S201, the predicted value of the removal amount calculated in step S202, and the indicator value calculated in step S203. One record indicates one calculation result. The control unit 11 may save the results of processing in steps S201 to S203 in such a data table format in the storage unit 12. However, the data format used to save the results of calculation of the indicator value needs not be limited to a table format such as that described above, and may be selected as appropriate, depending on the embodiment. After calculating the indicator value, the control unit 11 advances the processing to the next step S204.

Step S204

In the next step S204, the control unit 11 functions as the output unit 115, and compares the indicator value calculated in step S203 with a preset threshold value. Then, as a result of this comparison, if the control unit 11 judges that the indicator value exceeds the threshold value, the processing is advanced to the next step S205. On the other hand, if the control unit 11 judges that the indicator value does not exceed the threshold value, the processing of the next step S205 is skipped, and the processing of the monitoring phase according to this operation example is ended.

Note that the threshold value may be determined as appropriate. For example, the control unit 11 may set an n-fold (e.g., threefold) value of the standard deviation that has been calculated in the above-described step S102, as the threshold value. Moreover, for example, the threshold value may also be set based on the difference between an output value obtained by inputting the values of the accumulated operating time and the accumulated number of processed wafers when an abnormality has occurred in the etching process of the wet etching apparatus 3 to the predictive model 122 and the value of the removal amount when the abnormality has occurred. Note that the control unit 11 can acquire the values of the accumulated operating time, the accumulated number of processed wafers, and the removal amount when an abnormality such as the removal unevenness has occurred, from the operation data when the abnormality has occurred. Also, the control unit 11 can acquire the operation data as in the above-described steps S101 and S201.

Step S205

In the next step S205, the control unit 11 functions as the output unit 115, and outputs information regarding replacement of the chemical solution based on the indicator value calculated in step S203. According to this embodiment, the control unit 11 outputs a message for prompting replacement of the chemical solution, as the information regarding replacement of the chemical solution.

The destination to which the message is to be output may be selected as appropriate, depending on the embodiment. For example, the control unit 11 may output the message via the output device 15. Specifically, the control unit 11 may display the message on a display, or may output the message by voice from a loudspeaker. Also, for example, the control unit 11 may output the message to an external device by electronic mail or the like. In this case, the address of the external device serving as the destination of the message may be stored in the storage unit 12, for example.

Upon completion of the output of the information regarding replacement of the chemical solution, the control unit 11 ends the processing of the monitoring phase according to this operation example. Note that, after ending the processing of the monitoring phase, the control unit 11 may again execute processing from step S201. In this manner, the monitoring system 1 may continuously monitor the state of the chemical solution in the wet etching apparatus 3.

[Features]

As described above, in the embodiment, a predictive model that predicts the value of the removal amount from the values of the accumulated operating time and the accumulated number of processed wafers can be appropriately constructed through processing of steps S101 and S102 above. Also, through processing of steps S201 to S205 above, a predicted value of the removal amount with respect to the wet etching apparatus 3 when it is in operation can be derived using the constructed predictive model, the difference between the predicted value and a corresponding actual value of the removal amount can be calculated as an indicator value, and information regarding replacement of the chemical solution can be output based on the calculated indicator value.

Therefore, according to this embodiment, the timing at which removal unevenness will occur in the wet etching apparatus 3 can be appropriately predicted based on the above-described findings of the inventors of the present invention. Accordingly, use of the monitoring system 1 according to this embodiment can suppress excessive replacement of the chemical solution in the wet etching apparatus 3, and can reduce the wet etching cost.

§4 Modifications

Although the embodiment of the present invention has been described above in detail, the above descriptions are merely examples of the present invention in all aspects. Needless to say, various improvements and modifications may be made without departing from the scope of the present invention. For example, the following modifications are possible. Note that, in the following description, the same constituent elements as the constituent elements described in the above embodiment are assigned the same signs, and descriptions of the same points as the points described in the above embodiment are omitted as appropriate. The following modifications may be combined as appropriate.

<4.1>

In FIGS. 3 and 4 above, the monitoring system 1 according to this embodiment is constituted by a single computer. However, the configuration of the monitoring system 1 needs not be limited to this example, and may be selected as appropriate, depending on the embodiment. For example, it is also possible to extract constituent elements corresponding to the learning phase or the monitoring phase of the monitoring system 1 and construct a system, an apparatus, a method, a program, and a storage medium storing the program according to another embodiment.

FIG. 11 schematically shows an example of a software configuration of a monitoring system 1A according to a modification. The monitoring system 1A is constituted by a learning apparatus 21 and a monitoring apparatus 22. The learning apparatus 21 and the monitoring apparatus 22 may respectively have the same hardware configurations as those of the monitoring system 1 described above. The learning apparatus 21 and the monitoring apparatus 22 each may be an information processing apparatus designed exclusively for a service to be provided, as well as a general-purpose server device, a PC, a PLC (programmable logic controller), or the like.

The learning apparatus 21 is configured as a computer including the learning data acquisition unit 111 and the model construction unit 112 as software modules that are realized by the computer executing a program stored in a storage unit, using a control unit (CPU). On the other hand, the monitoring apparatus 22 is configured as a computer including the actual value acquisition unit 113, the indicator value calculation unit 114, and the output unit 115 as software modules that are realized by the computer executing a program stored in a storage unit, using a control unit.

Thus, the learning apparatus 21 executes the processing of the above-described steps S101 and S102 of the learning phase. The monitoring apparatus 22 executes the processing of the above-described steps S201 to S205 of the monitoring phase. Note that the predictive model 122 constructed by the learning apparatus 21 may be transmitted from the learning apparatus 21 to the monitoring apparatus 22 as appropriate. Data that indicates the predictive model 122 may be transmitted via a network or the like, for example. In this case, the learning apparatus 21 and the monitoring apparatus each include a communication interface for performing data communication via a network, as appropriate.

<4.2>

In the embodiment, the control unit 11 compares the indicator value and the threshold value (step S204), and if the indicator value exceeds the threshold value, the control unit 11 outputs a message for prompting replacement of the chemical solution, as the information regarding replacement of the chemical solution (step S205). However, the output method and contents of the information regarding replacement of the chemical solution need not be limited to this example, and may also be determined as appropriate, depending on the embodiment. For example, step S204 may be omitted. Also, the control unit 11 may output the indicator value calculated in step S203 on an as-is basis, as the information regarding replacement of the chemical solution.

<4.3>

In the embodiment, in each of the learning phase and the monitoring phase, the monitoring system 1 acquires the values of the accumulated operating time, the accumulated number of processed wafers, and the removal amount based on the operation data of the wet etching apparatus 3. However, the method for acquiring these values needs not be limited to this example, and may be selected as appropriate, depending on the embodiment.

For example, the monitoring system 1 may acquire the value of the accumulated operating time by counting time from when the chemical solution has been replaced to immediately before the etching process has been applied to a wafer, based on a timer (not shown) or the like. Also, the monitoring system 1 may acquire the value of the accumulated number of processed wafers by counting the number of wafers to which the etching process has been applied after replacement of the chemical solution.

Moreover, the monitoring system 1 may also measure the resistance value of a wafer before and after the etching process is performed, calculate the amount of change in the resistance value of the wafer using the difference between the obtained measured values, and derive the removal amount removed by etching from the wafer, based on the calculated amount of change in the resistance value of the wafer. With this method, the removal amount removed from the wafer can be simply and accurately measured. However, the method for specifying the removal amount needs not be limited to this example, and may be selected as appropriate, depending on the embodiment. For example, the monitoring system 1 may also measure the weight of a wafer before and after the etching process is performed, and calculate the removal amount removed by etching from the wafer, using the difference between the obtained measured values. Moreover, for example, the monitoring system 1 may also measure a step that has been formed on a wafer as a result of the etching process, and derive the removal amount removed by etching based on the depth of the step. Furthermore, for example, the monitoring system 1 may also measure the width of a pattern that has been formed on the wafer as a result of the etching process, and derive the removal amount removed by etching based on the measured value of the width.

<4.4>

In the above-described step S205, the control unit 11 of the monitoring system 1 functions as the output unit 115, and outputs a message for prompting replacement of the chemical solution, as the information regarding replacement of the chemical solution. However, the information regarding replacement of the chemical solution needs not be limited to such a message, and may be determined as appropriate, depending on the embodiment.

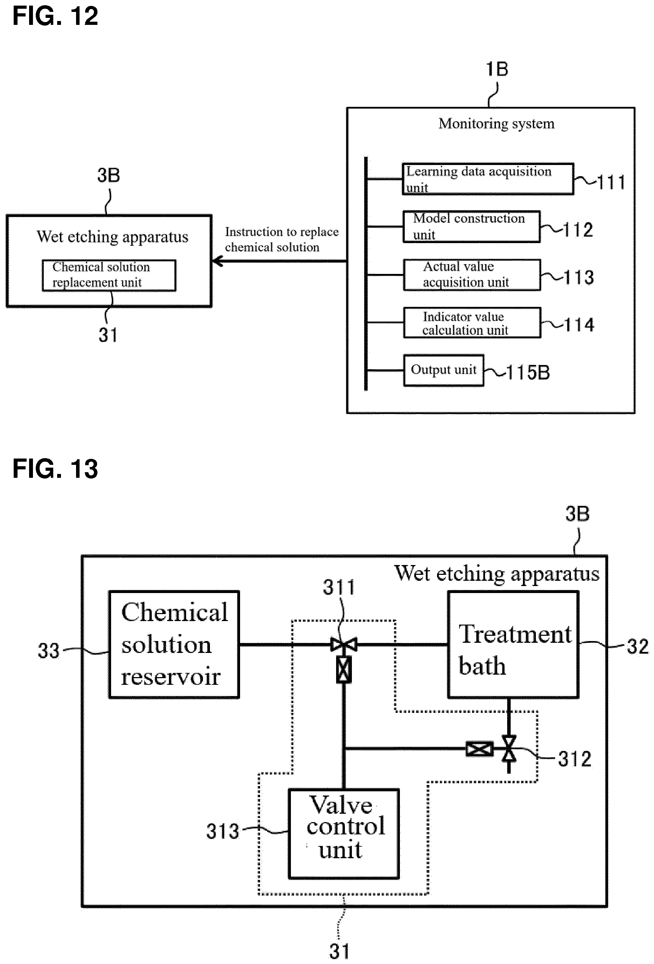

FIG. 12 schematically shows an example of a configuration of a monitoring system 1B according to a modification. FIG. 13 schematically shows an example of a configuration of a wet etching apparatus 3B according to this modification. In this modification, the wet etching apparatus 3B includes a chemical solution replacement unit 31 configured to perform replacement of the chemical solution. In the example in FIG. 13, the wet etching apparatus 3B further includes a treatment bath 32 configured to enable the etching process of a wafer to be performed therein, and a chemical solution reservoir 33 configured to store a chemical solution for use in the etching process and supply the chemical solution to the treatment bath 32. The chemical solution replacement unit 31 according to this modification is constituted by a solution supply valve 311, a solution discharge valve 312, and a valve control unit 313. The valve control unit 313 controls the operation of the valves (311 and 312). The solution supply valve 311 is provided on piping that connects the chemical solution reservoir 33 and the treatment bath 32, and supplies the chemical solution from the chemical solution reservoir 33 to the treatment bath 32 in response to an instruction from the valve control unit 313. The solution discharge valve 312 is provided on piping that connects the treatment bath 32 and a waste solution tank (not shown), and discharges the chemical solution from the treatment bath 32 to the waste solution tank in response to an instruction from the valve control unit 313. On the other hand, an output unit 115B of the monitoring system 1B outputs an instruction to replace the chemical solution to the chemical solution replacement unit 31 of the wet etching apparatus 3B, as the information regarding replacement of the chemical solution. Note that, except that the contents of the output are different, the monitoring system 1B has the same configuration as the above-described monitoring system 1.

In this case, the control unit of the monitoring system 1B executes the processing of steps S101 and S102 and the processing of steps S201 to S204 in the same manner as the above-described monitoring system 1. Then, in step S205, the control unit of the monitoring system 1B functions as the output unit 115B, and outputs an instruction to replace the chemical solution to the chemical solution replacement unit 31 of the wet etching apparatus 3B. Upon receiving this instruction, the chemical solution replacement unit 31 of the wet etching apparatus 3B executes replacement of the chemical solution. Specifically, upon receiving the instruction from the monitoring system 1B, the valve control unit 313 opens the solution discharge valve 312 and controls the discharge of the chemical solution from the treatment bath 32 to the waste solution tank. After the discharge of the chemical solution has been completed, the valve control unit 313 opens the solution supply valve 311 and controls the supply of the chemical solution from the chemical solution reservoir 33 to the treatment bath 32. Thus, replacement of the chemical solution can be automated. Note that the configuration of the chemical solution replacement unit 31 needs not be limited to the above-described example, and may be determined as appropriate, depending on the embodiment.

LIST OF REFERENCE NUMERALS

1 ... monitoring system,
11 ... control unit, 12 ... storage unit, 13 ... external interface,
14 ... input device, 15 ... output device, 16 ... drive,
111 ... learning data acquisition unit, 112 ... model construction unit,
113 ... actual value acquisition unit, 114 ... indicator value calculation unit, 115 ... output unit,
121 ... learning data, 122 ... predictive model,
3 ... wet etching apparatus,
8 ... program, 9 ... storage medium.

Claims

1. A learning apparatus (21) **characterized by** comprising:

a learning data acquisition unit (111) configured to acquire, as learning data (121), a set of normal values of:

an accumulated operating time indicating the accumulated time for which a wet etching apparatus (3; 3B) has operated from when a chemical solution has been replaced to when an etching process has been applied to one wafer,

an accumulated number of processed wafers indicating the accumulated number of wafers that have been processed from when the chemical solution has been replaced to when the etching process has been applied to the one wafer, and

a removal amount indicating the amount that has been removed by etching from the one wafer to which the etching process has been applied; and

a model construction unit (112) configured to construct a predictive model (122) that predicts a value of the removal amount depending on values of the accumulated operating time and the accumulated number of processed wafers, based on the normal values of the accumulated operating time, the accumulated number of processed wafers, and the removal amount contained in the learning data (121).

2. The learning apparatus (1; 1A; 1B) according to claim 1,
wherein the model construction unit (112) is configured to construct the predictive model (122) by performing regression analysis of normal values of the accumulated operating time, the accumulated number of processed wafers, and the removal amount contained in the learning data (121).

3. A monitoring system (1; 1A; 1B) for monitoring the state of a chemical solution used in an etching process performed by a wet etching apparatus (3; 3B), the monitoring system (1; 1A; 1B) comprising:

the learning apparatus (21) according to claim 1 or 2;
an actual value acquisition unit (113) configured to acquire actual values of the accumulated operating time, the accumulated number of processed wafers, and the removal amount with respect to the wet etching apparatus (3; 3B) when it is in operation;
an indicator value calculation unit (114) configured to calculate a predicted value of the removal amount by inputting the acquired actual values of the accumulated operating time and the accumulated number of processed wafers to the predictive model (122), and calculate the difference between the calculated predicted value and the acquired actual value of the removal amount, as an indicator value serving as a measure of how necessary it is to replace the chemical solution; and
an output unit (115; 115B) configured to output information regarding replacement of the chemical solution based on the calculated indicator value.

4. The monitoring system (1; 1A; 1B) according to claim 3,
wherein the output unit (115; 115B) is configured to:

compare the calculated indicator value and a threshold value, and
output a message for prompting replacement of the chemical solution as the information regarding replacement of the chemical solution, if it is judged that the indicator value exceeds the threshold value as a result of the comparison.

5. The monitoring system (1; 1A; 1B) according to claim 4,
wherein the threshold value is set based on the difference between an output value obtained by inputting values of the accumulated operating time and the accumulated number of processed wafers when an abnormality has occurred during the etching process in the wet etching apparatus (3; 3B) to the predictive model (122) and a value of the removal amount when the abnormality has occurred.

6. The monitoring system (1B) according to any one of claims 3 to 5,

wherein the wet etching apparatus (3B) includes a chemical solution replacement unit (31) configured to perform replacement of the chemical solution, and
the output unit (115B) is configured to output an instruction to replace the chemical solution to the chemical solution replacement unit (31) of the wet etching apparatus (3B), as the information regarding replacement of the chemical solution.

7. A learning method **characterized by** comprising:

a step of acquiring, as learning data (121), a set of normal values of:

an accumulated operating time indicating the accumulated time for which a wet etching apparatus (3; 3B) has operated from when a chemical solution has been replaced to when an etching process has been applied to one wafer,
an accumulated number of processed wafers indicating the accumulated number of wafers that have been processed from when the chemical solution has been replaced to when the etching process has been applied to the one wafer, and
a removal amount indicating the amount that has been removed by etching from the one wafer to which the etching process has been applied; and

a step of constructing a predictive model (122) that predicts a value of the removal amount depending on values of the accumulated operating time and the accumulated number of processed wafers, based on the normal values of the accumulated operating time, the accumulated number of processed wafers, and the removal amount contained in the learning data (121).

8. A monitoring method comprising:

the steps of the learning method according to claim 7;
a step of calculating a predicted value of the removal amount by inputting the acquired actual values of the accumulated operating time and the accumulated number of processed wafers to the predictive model (122);
a step of calculating the difference between the calculated predicted value and the acquired actual value of the removal amount, as an indicator value serving as a measure of how necessary it is to replace the chemical solution; and
a step of outputting information regarding replacement of the chemical solution based on the calculated indicator value..

9. A computer program comprising instructions to cause the device of claim 1 to execute the steps of the method of claim 7.

10. A computer-readable medium having stored thereon the computer program of claim 9.

11. A computer program comprising instructions to cause the device of claim 3 to execute the steps of the method of claim 8.

12. A computer-readable medium having stored thereon the computer program of claim 11.

**Patentansprüche**

1. Lernvorrichtung (21), **dadurch gekennzeichnet, dass** sie umfasst:

eine Lerndatenerfassungseinheit (111), die eingerichtet ist zum Erfassen, als Lerndaten (121), eines Satzes normaler Werte von:

einer akkumulierten Betriebszeit, die die akkumulierte Zeit angibt, für die eine Nassätzvorrichtung (3; 3B) betrieben worden ist, seit eine chemische Lösung ersetzt wurde und bis ein Ätzvorgang auf einen Wafer angewendet wurde,
einer akkumulierten Anzahl bearbeiteter Wafer, die die akkumulierte Anzahl Wafer angibt, die bearbeitet wurden, seit die chemische Lösung ersetzt wurde und bis der Ätzvorgang auf den einen Wafer angewendet wurde, und
einer Entfernungsmenge, die die Menge angibt, die durch Ätzen von dem einen Wafer, auf den der Ätzvorgang angewendet wurde, entfernt wurde; und

eine Modellkonstruktionseinheit (112), die dazu eingerichtet ist, ein Vorhersagemodells (122) zu konstruieren, das in Abhängigkeit von Werten der akkumulierten Betriebszeit und der akkumulierten Anzahl bearbeiteter Wafer basierend auf den normalen Werten der akkumulierten Betriebszeit, der akkumulierten Anzahl bearbeiteter Wafer und der Entfernungsmenge, die in den Lerndaten (121) enthalten sind, einen Wert der Entfernungsmenge vorhersagt.

2. Lernvorrichtung (1; 1A; 1B) nach Anspruch 1, wobei die Modellkonstruktionseinheit (112) dazu eingerichtet ist, das Vorhersagemodell (122) durch Durchführen einer Regressionsanalyse normaler Werte der akkumulierten Betriebszeit, der akkumulierten Anzahl bearbeiteter Wafer und der Entfernungsmenge, die in den Lerndaten (121) enthalten sind, zu konstruieren.

3. Überwachungssystem (1; 1A; 1B) zum Überwachen des Zustands einer chemischen Lösung, die in einem Ätzvorgang verwendet wird, der durch eine Nassätzvorrichtung (3; 3B) durchgeführt wird, wobei das Überwachungssystem (1; 1A; 1B) umfasst:

die Lernvorrichtung (21) nach Anspruch 1 oder 2;
eine Istwerterfassungseinheit (113), die dazu eingerichtet ist, Istwerte der akkumulierten Betriebszeit, der akkumulierten Anzahl bearbeiteter Wafer und der Entfernungsmenge in Bezug auf die Nassätzvorrichtung (3; 3B) zu erfassen, wenn sie in Betrieb ist;
eine Indikatorwertberechnungseinheit (114), die dazu eingerichtet ist, durch Eingeben der erfassten Istwerte der akkumulierten Betriebszeit und der akkumulierten Anzahl bearbeiteter Wafer in das Vorhersagemodell (122) einen vorhergesagten Wert der Entfernungsmenge zu berechnen und die Differenz zwischen dem berechneten vorhergesagten Wert und dem erfassten Istwert der Entfernungsmenge als Indikatorwert zu berechnen, der als ein Maß dafür dient, wie notwendig es ist, die chemische Lösung zu ersetzen; und

eine Ausgabeeinheit (115; 115B), die dazu eingerichtet ist, basierend auf dem berechneten Indikatorwert Informationen bezüglich eines Ersetzens der chemischen Lösung auszugeben.

4. Überwachungssystem (1; 1A; 1B) nach Anspruch 3, wobei die Ausgabeeinheit (115; 115B) dazu eingerichtet ist:

den berechneten Indikatorwert und einen Schwellenwert zu vergleichen, und als die Informationen bezüglich des Ersetzens der chemischen Lösung eine Nachricht auszugeben, die zum Ersetzen der chemischen Lösung auffordert, wenn als Ergebnis des Vergleichens beurteilt wird, dass der Indikatorwert den Schwellenwert überschreitet.

5. Überwachungssystem (1; 1A; 1B) nach Anspruch 4, wobei der Schwellenwert gewählt wird basierend auf der Differenz zwischen einem Ausgabewert, der durch Eingeben von Werten der akkumulierten Betriebszeit und der akkumulierten Anzahl bearbeiteter Wafer in das Vorhersagemodell (122) erhalten wird, wenn während des Ätzvorgangs in der Nassätzvorrichtung (3; 3B) eine Anomalie aufgetreten ist, und einem Wert der Entfernungsmenge, wenn die Anomalie aufgetreten ist.

6. Überwachungssystem (1B) nach einem der Ansprüche 3 bis 5,

wobei die Nassätzvorrichtung (3B) eine Chemische-Lösung-Ersetzungseinheit (31) aufweist, die dazu eingerichtet ist, das Ersetzen der chemischen Lösung durchzuführen, und die Ausgabeeinheit (115B) dazu eingerichtet ist, als die Informationen bezüglich des Ersetzens der chemischen Lösung eine Anweisung zum Ersetzen der chemischen Lösung an die Chemische-Lösung-Ersetzungseinheit (31) der Nassätzvorrichtung (3B) auszugeben.

7. Lernverfahren, **dadurch gekennzeichnet, dass** es umfasst:

einen Schritt mit Erfassen, als Lerndaten (121), eines Satzes normaler Werte von:

einer akkumulierten Betriebszeit, die die akkumulierte Zeit angibt, für die eine Nassätzvorrichtung (3; 3B) betrieben worden ist, seit eine chemische Lösung ersetzt wurde und bis ein Ätzvorgang auf einen Wafer angewendet wurde,
einer akkumulierten Anzahl bearbeiteter Wafer, die die akkumulierte Anzahl Wafer angibt, die bearbeitet wurden, seit die chemische Lösung ersetzt wurde und bis der Ätzvorgang auf den einen Wafer angewendet wurde, und
einer Entfernungsmenge, die die Menge angibt, die durch Ätzen von dem einen Wafer, auf den der Ätzvorgang angewendet wurde, entfernt wurde; und

einen Schritt mit Konstruieren eines Vorhersagemodells (122), das in Abhängigkeit von Werten der akkumulierten Betriebszeit und der akkumulierten Anzahl bearbeiteter Wafer basierend auf den normalen Werten der akkumulierten Betriebszeit, der akkumulierten Anzahl bearbeiteter Wafer und der Entfernungsmenge, die in den Lerndaten (121) enthalten sind, einen Wert der Entfernungsmenge vorhersagt.

8. Überwachungsverfahren, umfassend:

die Schritte des Lernverfahrens nach Anspruch 7;
einen Schritt mit Berechnen eines vorhergesagten Werts der Entfernungsmenge durch Eingeben der erfassten Istwerte der akkumulierten Betriebszeit und der akkumulierten Anzahl bearbeiteter Wafer in das Vorhersagemodell (122);
einen Schritt mit Berechnen der Differenz zwischen dem berechneten vorhergesagten Wert und dem erfassten Istwert der Entfernungsmenge als Indikatorwert, der als ein Maß dafür dient, wie notwendig es ist, die chemische Lösung zu ersetzen; und
einen Schritt mit Ausgeben von Informationen bezüglich eines Ersetzens der chemischen Lösung basierend auf dem berechneten Indikatorwert.

9. Computerprogramm, umfassend Anweisungen, um die Vorrichtung nach Anspruch 1 zu veranlassen, die Schritte des Verfahrens nach Anspruch 7 auszuführen.

10. Computerlesbares Medium, auf dem das Computerprogramm nach Anspruch 9 gespeichert ist.

11. Computerprogramm, umfassend Anweisungen, um die Vorrichtung nach Anspruch 3 zu veranlassen, die Schritte des Verfahrens nach Anspruch 8 auszuführen.

**12.** Computerlesbares Medium, auf dem das Computerprogramm nach Anspruch 11 gespeichert ist.

**Revendications**

**1.** Appareil d'apprentissage (21) **caractérisé en ce qu'**il comprend :

une unité d'acquisition de données d'apprentissage (111) configurée pour acquérir, en tant que données d'apprentissage (121), un ensemble de valeurs normales :

d'un temps de fonctionnement cumulé indiquant le temps cumulé pendant lequel un appareil de gravure humide (3 ; 3B) a fonctionné à partir du moment auquel une solution chimique a été remplacée jusqu'au moment auquel un traitement de gravure a été appliqué à une tranche,
d'un nombre cumulé de tranches traitées indiquant le nombre cumulé de tranches qui ont été traitées à partir du moment auquel la solution chimique a été remplacée jusqu'au moment auquel le traitement de gravure a été appliqué à ladite tranche, et
d'une quantité d'élimination indiquant la quantité qui a été éliminée par une gravure de ladite tranche à laquelle a été appliqué le traitement de gravure ; et

une unité de construction de modèle (112) configurée pour construire un modèle prédictif (122) qui prédit une valeur de la quantité d'élimination en fonction de valeurs du temps de fonctionnement cumulé et du nombre cumulé de tranches traitées, sur la base des valeurs normales du temps de fonctionnement cumulé, du nombre cumulé de tranches traitées et de la quantité d'élimination contenues dans les données d'apprentissage (121).

**2.** Appareil d'apprentissage (1 ; 1A ; 1B) selon la revendication 1,
dans lequel l'unité de construction de modèle (112) est configurée pour construire le modèle prédictif (122) par une mise en œuvre d'une analyse de régression de valeurs normales du temps de fonctionnement cumulé, du nombre cumulé de tranches traitées et de la quantité d'élimination contenues dans les données d'apprentissage (121).

**3.** Système de surveillance (1; 1A; 1B) destiné à surveiller l'état d'une solution chimique utilisée lors d'un traitement de gravure mis en œuvre par un appareil de gravure humide (3 ; 3B), le système de surveillance (1; 1A; 1B) comprenant :

l'appareil d'apprentissage (21) selon la revendication 1 ou la revendication 2 ;
une unité d'acquisition de valeur courante (113) configurée pour acquérir des valeurs courantes du temps de fonctionnement cumulé, du nombre cumulé de tranches traitées et de la quantité d'élimination par rapport à l'appareil de gravure humide (3 ; 3B) lorsqu'il est en fonctionnement ;
une unité de calcul de valeur d'indicateur (114) configurée pour calculer une valeur prédite de la quantité d'élimination par une entrée des valeurs courantes acquises du temps de fonctionnement cumulé et du nombre cumulé de tranches traitées dans le modèle prédictif (122), et pour calculer la différence entre la valeur prédite calculée et la valeur courante acquise de la quantité d'élimination, en tant que valeur d'indicateur servant de mesure de nécessité de remplacement de la solution chimique ; et
une unité de sortie (115 ; 115B) configurée pour délivrer des informations concernant un remplacement de la solution chimique sur la base de la valeur d'indicateur calculée.

**4.** Système de surveillance (1 ; 1A ; 1B) selon la revendication 3,
dans lequel l'unité de sortie (115 ; 115B) est configurée pour :

comparer la valeur d'indicateur calculée et une valeur seuil, et
délivrer un message ayant pour objet d'inviter à un remplacement de la solution chimique en tant que les informations concernant un remplacement de la solution chimique, s'il est évalué que la valeur d'indicateur dépasse la valeur seuil en tant que résultat de la comparaison.

**5.** Système de surveillance (1 ; 1A ; 1B) selon la revendication 4,
dans lequel la valeur seuil est définie sur la base de la différence entre une valeur de sortie obtenue par une entrée de valeurs du temps de fonctionnement cumulé et du nombre cumulé de tranches traitées lorsqu'une anomalie s'est produite durant le traitement de gravure mis en œuvre dans l'appareil de gravure humide (3 ; 3B) par rapport au modèle prédictif (122) et une valeur de la quantité d'élimination lorsque l'anomalie s'est produite.

**6.** Système de surveillance (1B) selon l'une quelconque des revendications 3 à 5,

dans lequel l'appareil de gravure humide (3B) comprend une unité de remplacement de solution chimique (31) configurée pour mettre en œuvre un remplacement de la solution chimique, et

l'unité de sortie (115B) est configurée pour délivrer une instruction ayant pour objet de remplacer la solution chimique à l'unité de remplacement de solution chimique (31) de l'appareil de gravure humide (3B), en tant que les informations concernant un remplacement de la solution chimique.

7. Procédé d'apprentissage **caractérisé en ce qu'**il comprend :

une étape consistant à acquérir, en tant que données d'apprentissage (121), un ensemble de valeurs normales :

d'un temps de fonctionnement cumulé indiquant le temps cumulé pendant lequel un appareil de gravure humide (3 ; 3B) a fonctionné à partir du moment auquel une solution chimique a été remplacée jusqu'au moment auquel un traitement de gravure a été appliqué à une tranche,
d'un nombre cumulé de tranches traitées indiquant le nombre cumulé de tranches qui ont été traitées à partir du moment auquel la solution chimique a été remplacée jusqu'au moment auquel le traitement de gravure a été appliqué à ladite tranche, et
une quantité d'élimination indiquant la quantité qui a été éliminée par une gravure de ladite tranche à laquelle a été appliqué le traitement de gravure ; et

une étape consistant à construire un modèle prédictif (122) qui prédit une valeur de la quantité d'élimination en fonction de valeurs du temps de fonctionnement cumulé et du nombre cumulé de tranches traitées, sur la base des valeurs normales du temps de fonctionnement cumulé, du nombre cumulé de tranches traitées et de la quantité d'élimination contenues dans les données d'apprentissage (121).

8. Procédé de surveillance, comprenant :

les étapes du procédé d'apprentissage selon la revendication 7 ;
une étape consistant à calculer une valeur prédite de la quantité d'élimination par une entrée des valeurs courantes acquises du temps de fonctionnement cumulé et du nombre cumulé de tranches traitées dans le modèle prédictif (122) ;
une étape consistant à calculer la différence entre la valeur prédite calculée et la valeur courante acquise de la quantité d'élimination, en tant que valeur d'indicateur servant de mesure de nécessité de remplacement de la solution chimique ; et
une étape consistant à délivrer des informations concernant un remplacement de la solution chimique sur la base de la valeur d'indicateur calculée.

9. Programme informatique comprenant des instructions destinées à amener le dispositif selon la revendication 1 à exécuter les étapes du procédé selon la revendication 7.

10. Support lisible par ordinateur contenant en mémoire le programme informatique selon la revendication 9.

11. Programme informatique comprenant des instructions destinées à amener le dispositif selon la revendication 3 à exécuter les étapes du procédé selon la revendication 8.

12. Support lisible par ordinateur contenant en mémoire le programme informatique selon la revendication 11.

**FIG. 1**

(Predicted value of removal amount)
− (Actual value of removal amount)
= (Indicator value serving as measure of how
necessary it is to replace chemical solution)

# FIG. 2B

# FIG. 3

Monitoring system

12 — Storage unit
8 — Program
14 — Input device
15 — Output device
9 — Storage medium
Drive
16

Control unit
CPU
RAM
ROM
External I/F
13

1
11

## FIG. 4

## FIG. 5

# FIG. 6

| Check time | Lot ID | Batch ID | ... | Accumulated operating time | Accumulated number of processed wafers | Removal amount | ... | Amount of chemical solution | Solution concentration | ... |
|---|---|---|---|---|---|---|---|---|---|---|
| 2015/4/7 3:36:42 | L1 | 025 | ... | 315,650 | 5,250 | 1299 | ... | 202.59 | 0.021 | ... |
| 2015/4/10 2:44:31 | L2 | 023 | ... | 125 | 6,600 | 1254 | ... | 188.88 | 0.021 | ... |
| ⋮ | ⋮ | ⋮ | ⋮ | ⋮ | ⋮ | | ⋮ | ⋮ | ⋮ | ⋮ |

# FIG. 7

| Check time | Accumulated operating time | Accumulated number of processed wafers | Removal amount | Flag |
|---|---|---|---|---|
| 2015/4/7 3:36:42 | 315,650 | 5,250 | 1299 | FALSE |
| 2015/4/10 2:44:31 | 125 | 6,600 | 1254 | TRUE |
| ⋮ | ⋮ | ⋮ | ⋮ | ⋮ |

# FIG. 8

| $C_0$ | $C_1$ | $C_2$ | Rsd |
|---|---|---|---|
| 1303.5 | 1.153 | −2.641 | 75.17 |

# FIG. 9

```
                    ┌─────────────┐
                    │    Start    │
                    └─────────────┘
                           │
                           ▼
        ┌──────────────────────────────────────────────┐
        │ Acquire actual values of accumulated operating time, │
S201    │ accumulated number of processed wafers, and removal  │
        │ amount with respect to wet etching apparatus when it is │
        │ in operation                                  │
        └──────────────────────────────────────────────┘
                           │
                           ▼
        ┌──────────────────────────────────────────────┐
S202    │ Calculate predicted value of removal amount   │
        │ using predictive model                        │
        └──────────────────────────────────────────────┘
                           │
                           ▼
        ┌──────────────────────────────────────────────┐
S203    │ Calculate difference between predicted value and │
        │ actual value of removal amount as indicator value │
        └──────────────────────────────────────────────┘
                           │
                           ▼
                   ╱─────────────╲
                  ╱ Does indicator ╲        YES
S204     ────────╱ value exceed threshold ╲────────────┐
                 ╲     value?     ╱                     │
                  ╲─────────────╱                       │
                        │ NO                            ▼
                        │          ┌──────────────────────────────────┐
                        │          │ Output message for prompting replacement of │  S205
                        │          │ chemical solution                │
                        │          └──────────────────────────────────┘
                        │                     │
                        │◄────────────────────┘
                        ▼
                    ┌─────────────┐
                    │     End     │
                    └─────────────┘
```

## FIG. 10

| Check time | Removal amount (actual value) | Accumulated operating time (actual value) | Accumulated number of processed wafers (actual value) | Removal amount (predicted value) | Indicator value |
|---|---|---|---|---|---|
| 2015/4/26 3:51:31 | 1278 | 4,870 | 11,345 | 1151.14 | 126.85 |
| 2015/5/6 2:44:00 | 1280 | 10,610 | 17,085 | 1169.42 | 110.57 |
| ⋮ | ⋮ | ⋮ | ⋮ | ⋮ | ⋮ |

## FIG. 11

## FIG. 12

1B

Monitoring system

3B

Wet etching apparatus

Chemical solution
replacement unit

31

Instruction to replace
chemical solution

Learning data acquisition
unit ~111

Model construction
unit ~112

Actual value
acquisition unit ~113

Indicator value
calculation unit ~114

Output unit ~115B

## FIG. 13

3B

Wet etching apparatus

311

Chemical
solution
reservoir

33

Treatment
bath

32

312

Valve
control
unit

313

31

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003031456 A

- US 20160126148 A1